# EUROPÄISCHE PATENTSCHRIFT

(11) **EP 1 997 133 B1**
(45) Veröffentlichungstag und Bekanntmachung des Hinweises auf die Patenterteilung: **19.08.2009**
(21) Anmeldenummer: 07723315.3
(22) Anmeldetag: 16.03.2007
(51) Int. Cl.: H01L 21/60

(54) **Verfahren zur Herstellung eines aktiven oder passiven elektronischen Bauteils und elektronisches Bauteil**
Method for producing an active or passive electronic component and electronic component
Procédé de fabrication d'un composant électronique actif ou passif et composant électronique

(30) Priorität: 17.03.2006 DE 102006012708; 30.05.2006 DE 102006025484
(43) Veröffentlichungstag der Anmeldung: 03.12.2008
(73) Patentinhaber: PolyIC GmbH & Co. KG, 90763 Fürth (DE)
(72) Erfinder: ULLMANN, Andreas, 90513 Zirndorf (DE); LUTZ, Norbert, 90607 Rückersdorf (DE); ATTNER, Juri, 90559 Burgthann (DE); STREB, Christina, 5646 Abtwil (CH); EPP, Sascha, CH-6300 Zug (CH)
(74) Vertreter: Zinsinger, Norbert
(86) Internationale Anmeldenummer: PCT/EP2007/002334
(87) Internationale Veröffentlichungsnummer: WO 2007/107299

(56) Entgegenhaltungen:
- WO-A-20/06011665
- FR-A1- 2 795 234
- US-A1- 2004 192 011

## Beschreibung

Die Erfindung betrifft ein Verfahren zur Herstellung eines aktiven oder passiven elektrischen Bauteils sowie ein danach erhältliches elektrisches Bauteil.

Ein derartiges Verfahren und derartige elektrische Bauteile sind aus DE 101 20 687 A1 oder aus US-A-2004/0192011 bekannt, wobei hier insbesondere RFID-Tags (Radio Frequence Ident Tags), OLEDs oder generell elektronische Schaltungen aus organischem Material beschrieben sind. Auf einem mehrschichtigen Trägersubstrat, welches eine Barriereschicht umfasst, ist eine Spule bzw. Antenne angeordnet, mit welcher als eine Art Aufkleber die Elektronik im Bereich der freiliegenden elektrischen Kontakte der entsprechenden Spüle bzw. Antenne verbunden ist. Die jeweiligen Enden einer Spule oder auch einer Antenne können mit der Elektronik durch einfaches Aufkleben verbunden werden. Die elektrischen Anschlussflächen der Elektronik und der Spule bzw. Antenne werden üblicherweise mit einem Leitkleber elektrisch leitend verbunden.

Es hat sich gezeigt, dass Leitkleber zwar eine gute elektrisch leitende Verbindung ausbilden, das allerdings die Haftkraft des Leitklebers nicht ausreichend ist, um eine mechanische Beanspruchung, insbesondere eine Biegebeanspruchung des elektrischen Bauteils unbeschadet zu überstehen. Wird beispielsweise ein RFID-Tag als Aufkleber für Logistik-Zwecke, Zugangskontrollen oder ähnliches verwendet, so wird der Aufkleber auf einen flexiblen Träger, wie zum Beispiel Verpackungsmaterial oder ähnliches aufgeklebt und ist einer solchen mechanischen Beanspruchung bzw. Biegebeanspruchung unterworfen. Es besteht dabei die Gefahr, dass der elektrische Kontakt zwischen Spule bzw. Antenne und Elektronikchip abreißt und ein Auslesen des Chips unmöglich wird.

Es ist nun Aufgabe der Erfindung, ein Verfahren zur Herstellung eines elektrischen Bauteils sowie ein derartiges elektrisches Bauteil bereitzustellen, das flexibel ist und einer mechanischen Beanspruchung, insbesondere einer Biegebeanspruchung standhält.

Die Aufgabe wird für das Verfahren gemäß Anspruch 1 gelöst.

Die Aufgabe wird für das elektrische Bauteil gemäß Anspruch 4 gelöst.

Durch das erfindungsgemäße Verfahren ist das erfindungsgemäße elektrische Bauteil erhältlich, in dem neben einer Leitkleberverbindung zwischen elektrisch leitenden Kontaktbereichen weiterhin eine elektrisch isolierende Haftkleberverbindung vorhanden ist, welche die Leitkleberverbindung nicht beeinträchtigt.

Die punkt- und/oder linienförmige Anordnung des Haftklebers ermöglicht einen großflächigen Haftkleberauftrag, welcher nicht im Hinblick auf bereits vorhandene Funktionsschichten oder weitere/zusätzliche Schichten registriert werden muss. Der punkt- bzw. linienförmige Haftkleber kann sich demnach über die gesamte beschichtete Trägersubstratoberfläche erstrecken und kann aufgrund seiner geringen Dimensionierung auch in dem Bereich angeordnet sein, in welchem Leitkleber zur Verbindung der elektrisch leitenden Kontaktbereiche aufgetragen werden muss.

Der Haftkleber wird bei der dekorförmigen Auftragung eher flächig ausgeformt und überzieht gegenüber der punkt- oder linienförmigen Anordnung größere Flächenbereiche. Die dekorförmige Anordnung des Haftklebers muss im Hinblick auf bereits vorhandene Funktionsschichten oder weitere/zusätzliche Schichten zumindest grob registriert werden. Der dekorförmige Haftkleber darf sich nicht komplett über Bereiche erstrecken, in welchen Leitkleber zur Verbindung der elektrisch leitenden Kontaktbereiche aufgetragen werden soll. Unter einer dekorförmigen Anordnung werden beispielsweise rahmen- oder ringförmige Strukturen, figürliche, alphanumerische oder geometrische Strukturen wie Rechtecke oder Kreise, insbesondere mit einer oder mehreren innerhalb deren Außenkontur der Struktur angeordneten Aussparungen an Haftkleber, und dergleichen verstanden.

Bei der Ausformung des Haftklebers im Register zu bereits vorhandenen Schichten oder Registermarkierungen ist üblicherweise mit einer Registertoleranz im Bereich von ± 0,2 mm auszugehen.

Besonders vorteilhaft ist es, dass der Leitkleber derart ausgewählt werden kann, dass ein ausgezeichneter elektrisch leitender Kontakt zwischen dem mindestens einen ersten elektrisch leitenden Kontaktbereich und dem mindestens einen zweiten elektrisch leitenden Kontaktbereich ausgebildet wird. Die Klebeigenschaften des Leitklebers sind dabei nur von untergeordneter Bedeutung, nachdem der Haftkleber, welcher elektrisch isolierend ausgebildet ist und lediglich zur Herstellung einer gut haftenden Klebverbindung zwischen den Funktionsschichten und gegebenenfalls weiteren/zusätzlichen Schichten dient, diese Eigenschaften separat bereitstellt. Der Haftkleber kann dabei lediglich im Hinblick auf seine Klebeigenschaften zwischen den zu verklebenden Schichten ausgewählt werden.

Besonders bevorzugt ist es, wenn für das Verfahren ein drittes Trägersubstrat bereitgestellt wird, auf welchem der Haftkleber punkt- und/oder linienförmig und/oder dekorförmig ausgebildet wird, wobei der Haftkleber vom dritten Trägersubstrat auf die erste Seite des ersten oder zweiten Trägersubstrats übertragen wird. Das dritte Trägersubstrat kann getrennt vom ersten Trägersubstrat vorbereitet und auch zwischengelagert werden.

Der Haftkleber kann auf das erste oder das zweite oder das dritte Trägersubstrat aufgetropft, aufgegossen, aufgetupft, aufgedruckt oder mittels Thermotransferverfahren oder Dispensen übertragen werden. Wird der Haftkleber direkt auf das erste oder das zweite Trägersubstrat aufgebracht, ist selbstverständlich ein drittes Trägersubstrat nicht erforderlich. Nachdem der Haftkleber auf das erste oder das zweite Trägersubstrat aufgetragen oder übertragen wurde, kann wiederum eine Zwischenlagerung des ersten oder zweiten Trägersubstrats erfolgen, bevor ein Zusammenführen mit dem zweiten bzw. ersten Trägersubstrat erfolgt.

Vorzugsweise sind das erste und/oder das zweite und/oder das dritte Trägersubstrat bandförmig ausgebildet. Dies ermöglicht eine kontinuierliche Durchführung des Verfahrens, wobei die bandförmigen Trägersubstrate von einer Rolle zu einer weiteren Rolle transportiert werden. So wird das erste bandförmige Trägersubstrat auf eine Rolle aufgewickelt bereitgestellt, von dieser abgezogen, mit der mindestens einen Funktionsschicht des elektrischen Bauteils und gegebenenfalls weiteren Schichten beschichtet und vor der Weiterverarbeitung vorzugsweise mit einem wieder ablösbaren Abdeckband versehen und auf eine weitere Rolle aufgewickelt. Das dritte Trägersubstrat, welches ebenfalls bandförmig ausgebildet sein kann, wird auf einer Rolle bereitgestellt, von dieser abgezogen, mit Haftkleber punkt- und/oder linienförmig und/oder dekorförmig beschichtet, mit einem wieder ablösbaren Abdeckband belegt und auf eine weitere Rolle aufgewickelt. Das bandförmige erste Trägersubstrat, welches bereits beschichtet ist, wird von der Vorratsrolle abgezogen, das Abdeckpapier separat aufgewickelt und mit dem dritten Trägersubstrat zusammengeführt, wobei auch das Abdeckband, mit welchem das dritte Trägersubstrat aufgewickelt wurde, separat abgezogen wird. Dabei wird der Haftkleber vom dritten Trägersubstrat auf beispielsweise das erste Trägersubstrat übertragen. Auch das zweite Trägersubstrat kann wie das erste Trägersubstrat behandelt werden und eine Übertragung des Haftklebers vom dritten Trägersubstrat auf das zweite Trägersubstrat erfolgen. Um einen Transport der Trägersubstrate von Rolle zu Rolle realisieren zu können, muss das bandförmige Trägersubstrat ausreichend flexibel sein. Als Maß für eine ausreichende Flexibilität ist hier eine Biegbarkeit des Trägersubstrats um eine Rolle mit einem Durchmesser von 1 cm bis 10 cm bevorzugt.

Es hat sich bewährt, wenn der Haftkleber thermisch und/oder mittels Strahlung und/oder mittels Druck aktiviert wird. Bei thermisch aktivierbarem Haftkleber handelt es sich üblicherweise um Heißkleber, wie sie bei Thermotransferfolien häufig eingesetzt werden. Mittels Strahlung aktivierbare Haftkleber sind üblicherweise solche, die mittels UV-Strahlung vernetzbar sind. Auch herkömmliche Kaltkleber, welche lediglich mittels Druck aktiviert werden, sind als Haftkleber gut geeignet. Im Hinblick auf die ausgewählte Aktivierungsart für den Haftkleber ist zu beachten, dass das Aktivieren die Eigenschaften der Funktionsschichten des elektrischen Bauteils nicht negativ beeinflussen darf. So dürfen beispielsweise Aktivierungstemperaturen für thermisch aktivierbare Haftkleber nicht so hoch gewählt werden, dass die Funktionsschicht oder Funktionsschichten des elektrischen Bauteils dadurch negativ beeinflusst werden.

Bei strahlungsvernetzenden Haftungsklebern ist weiterhin zu beachten, dass sofern strahlungsundurchlässige Trägersubstrate eingesetzt werden, eine Aktivierung gegebenenfalls bereits vor Zusammenführen von erstem und zweitem Trägersubstrat zu erfolgen hat. Sofern ausreichend strahlungstransparente Materialien eingesetzt werden, kann die Aktivierung des Haftklebers auch nach Zusammenführen des ersten und zweiten Trägersubstrats erfolgen.

Es hat sich bewährt, wenn der unaktivierte Haftkleber senkrecht zur Ebene des jeweiligen Trägersubstrats gesehen trocken in einer Dicke im Bereich von 5 µm bis 100 µm ausgebildet wird. Eine zu dünne Haftkleberschicht kann gegebenenfalls keine ausreichende Klebeverbindung zwischen den benachbarten elektrisch leitenden Kontaktbereichen, den Funktionsschichten oder weiteren/zusätzlichen Schichten ausbilden, während eine zu dicke Haftkleberschicht gegebenenfalls den elektrischen Kontakt zwischen den benachbarten elektrisch leitenden Kontaktbereichen negativ beeinflusst.

Vorteilhafterweise wird der Leitkleber als eine Leitkleberpaste ausgebildet, die senkrecht zur Ebene des ersten oder zweiten Trägersubstrats gesehen dicker als der Haftkleber ausgebildet wird. Beim Zusammenführen des mindestens einen ersten elektrisch leitenden Kontaktbereich mit dem mindestens einen zweiten elektrisch leitenden Kontaktbereichs und so lange die Leitkleberpaste feucht ist, ist ein Gegeneinanderdrücken der Kontaktbereiche möglich, wobei sich die Leitkleberpaste auch Unebenheiten zwischen den Kontaktbereichen optimal anpasst und die punkt- und/oder linienförmigen Haftkleberbereiche optimal umschließt oder an dekorförmige Haftkleberbereiche optimal angrenzt.

Es hat sich bewährt, wenn der Haftkleber punktförmig ausgebildet wird, wobei die Haftkleberpunkte in einem Raster angeordnet sind. Unter "punktförmig" wird hier nicht nur ein kreisförmiger Haftkleberpunkt verstanden, sondern es sind auch andere Formen an Haftkleberpunkten verwendbar. So können beispielsweise rechteckige Haftkleberpunkte, ovale Haftkleberpunkte oder sonstig geformte Haftkleberpunkte verwendet werden. Sofern die Haftkleberpunkte aus der flüssigen Phase auf das erste oder zweite Trägersubstrat übertragen werden, ist es am einfachsten, die kreisförmige oder ovale Form für den Haftkleberpunkt zu wählen. Sofern die Haftkleberpunkte in einem trockenen Transferverfahren, beispielsweise mittels des dritten Trägersubstrats auf das erste oder zweite Trägersubstrat übertragen werden, sind beliebige Formen an Haftkleberpunkten erzeugbar.

Vorzugsweise sind die Haftkleberpunkte senkrecht zur Ebene des ersten oder zweiten Trägersubstrats gesehen mit einem Durchmesser im Bereich von 100 µm bis 2 mm, insbesondere mit einem Durchmesser von etwa 500 µm, ausgebildet. Derart kleine Haftkleberpunkte gewährleisten eine möglichst geringe Beeinflussung des elektrischen Kontakts im Bereich des Leitklebers.

Weiterhin hat es sich bewährt, wenn die Haftkleberpunkte voneinander in einem Abstand von 0,5 mm bis 5 mm beabstandet angeordnet sind. Die Haftkleberpunkte sind bevorzugt voneinander in einem Abstand von 1 mm bis zu 2 mm beabstandet. Eine solche Anordnung der Haftkleberpunkte über die Fläche des ersten und/oder zweiten Trägersubstrats gewährleistet eine kontinuierliche Verklebung mit hoher Haftwirkung.

Weiterhin hat es sich als vorteilhaft erwiesen, den Haftkleber linienförmig auszubilden. Dabei können die Haftkleberlinien parallel zueinander angeordnet sein sowie ein Gitter bilden. Weiterhin kann der linienförmige Haftkleber derart aufgetragen sein, dass ein Dekor ausgebildet wird, das in Abstimmung zu bereits auf dem Trägersubstrat vorhandenen Funktionsschichten oder weiteren/zusätzlichen Schichten registriert ist. So können beispielsweise rund um den ersten elektrisch leitenden Kontaktbereich oder den zweiten elektrisch leitenden Kontaktbereich Haftkleberlinien einen geschlossenen Ring ausbilden, der den Leitkleber sozusagen allseitig umgibt und eine besonders gute Fixierung und Verklebung gewährleistet.

Vorteilhafterweise weisen die Haftkleberlinien senkrecht zur Ebene des ersten oder zweiten Trägersubstrats gesehen eine Breite im Bereich von 100 µm bis 2 mm auf. Derart dünne Linien können auch über die elektrisch leitenden Kontaktbereiche hinweg verlaufen, ohne dass die elektrisch leitende Verbindung zwischen den Kontaktbereichen mittels des Leitklebers beeinträchtigt ist.

Weiterhin ist es bevorzugt, wenn parallele Haftkleberlinien voneinander in einem Abstand von 0,5 mm bis 5 mm beabstandet angeordnet werden. Die Haftkleberlinien sind bevorzugt voneinander in einem Abstand von 1 mm bis 2 mm beabstandet. Dies ermöglicht auch im Bereich der elektrisch leitenden Kontaktbereiche eine ausreichende Zugänglichkeit für den Leitkleber.

Weiterhin hat es sich bewährt, den Haftkleber dekorförmig auszubilden, wobei der Haftkleber lediglich im Bereich des elektrischen Bauteils angeordnet wird und in mindestens einem Bereich eine Aussparung, in welcher Leitkleber aufgetragen wird, aufweist. Der Haftkleber erstreckt sich dabei lediglich in Bereichen, in denen senkrecht zum ersten Trägersubstrat gesehen mindestens auch eine Schicht, die dem elektrischen Bauteil zuzurechnen ist, vorhanden ist. Der Haftkleber weist vorzugsweise Aussparungen auf, die so dimensioniert sind, dass ein direkter Kontakt zwischen Leitkleber und Haftkleber im Bereich des elektrischen Bauteils vollständig vermieden wird.

Insbesondere hat es sich bewährt, wenn beim Zusammenführen des ersten Trägersubstrats und des zweiten Trägersubstrats der mindestens eine erste elektrisch leitende Kontaktbereich und der mindestens eine zweite elektrisch leitende Kontaktbereich gegeneinander gedrückt werden, wobei der trockene Haftkleber als - vorzugsweise elastischer - Abstandshalter zwischen dem mindestens einen ersten elektrisch leitenden Kontaktbereich und dem mindestens einen zweiten elektrischen leitenden Kontaktbereich dient. Dies gewährleistet eine gleichmäßige Leitkleber-Schichtdicke im Bereich zwischen erstem elektrisch leitenden Kontaktbereich und zweitem elektrisch leitenden Kontaktbereich, wobei die Güte des elektrischen Kontakts verbessert wird.

Es hat sich bewährt, den Leitkleber anschließend bei einer Temperatur im Bereich von 30 °C bis 130 °C, gegebenenfalls bis 150°C, auszuhärten bzw. zu vernetzen.

Die Aktivierung des Haftklebers kann gleichzeitig mit der Aktivierung des Leitklebers erfolgen oder die Aktivierung des Haftklebers kann vor oder erst nach der Aktivierung des Leitklebers erfolgen. Je nachdem, welche Typen von Haft- bzw. Leitkleber eingesetzt werden, sind auch unterschiedliche Aktivierungsarten möglich.

Bei Verwendung von beispielsweise druckaktivierbarem Kleber als Haftkleber und UV-vernetzendem Kleber als Leitkleber sind diese im wesentlichen ohne eine Temperatureinwirkung aktivierbar, so dass ein empfindliches elektrisches Bauteil, wie beispielsweise ein Polymerelektronikchip, besonders schonend gebildet werden kann. Wird zusätzlich zu einem Haftkleber aus druckaktivierbarem Kleber ein durch Temperatureinwirkung aktivierbarer Leitkleber eingesetzt, so müssen lediglich die Kontaktbereiche mit Leitkleber erwärmt werden, so dass das elektrische Bauteil ebenfalls nur lokal geringfügig thermisch belastet wird.

Es hat sich bewährt, wenn die Funktionsschichten des elektrischen Bauteils und die gegebenenfalls weiteren/zusätzlichen Schichten durch Drucken auf dem jeweiligen Trägersubstrat gebildet werden. Als Druckverfahren haben sich hierbei Offsetdruck, Tiefdruck, Flexodruck usw. bewährt.

Insbesondere hat es sich als vorteilhaft erwiesen, wenn die Funktionsschichten des elektrischen Bauteils und die gegebenenfalls vorhandenen weiteren/zusätzlichen Schichten als Polymerschichten ausgebildet werden. Die elektrischen Bauteile lassen sich dadurch sehr kostengünstig herstellen und sind daher für Massenmärkte und als Einwegprodukte einsetzbar.

Als Trägersubstrate zur Durchführung des Verfahrens haben sich insbesondere Kunststofffolien bewährt, wie Polyethylen (PE), Polyethylenterephthalat (PET), Polyimid (PI) und dergleichen. Trägersubstrate können sowohl einschichtig als auch mehrschichtig eingesetzt werden, wobei auch Barrierenschichten gemäß DE 101 20 687 A1 vorgesehen sein können. Die Kunststofffolie weist üblicherweise eine Dicke im Bereich von 10 bis 100 µm, vorzugsweise im Bereich von 30 bis 60 µm, auf. Als Barriereschicht kann etwa eine metallische Schicht oder eine Oxidschicht vorhanden sein, welche auf die Basisfolie aufgedampft oder auflaminiert ist. Geeignete Metalle sind hierfür beispielsweise Aluminium, Kupfer oder Chrom. Eine Metallschicht ist üblicherweise zwischen 5 und 100 µm, vorzugsweise zwischen 20 und 55 µm dick. Eine Oxidschicht bzw. eine nicht-metallische Schicht kann beispielsweise aus anorganischen Oxiden mit Plättchenstruktur oder auch aus Graphit gebildet sein.

Für das elektrische Bauteil hat es sich bewährt, wenn die mindestens eine erste Funktionsschicht eine strukturierte elektrisch leitende Schicht in Form einer Antennenstruktur ist. Die mindestens eine erste Funktionsschicht kann aber auch eine - optional strukturierte - elektrisch leitende Schicht sein, die Bestandteil eines Displays oder einer Stromversorgung ist.

Eine elektrisch leitende erste Funktionsschicht kann auf das Trägersubstrat in Form eine Metallfolie aufkaschiert oder auflaminiert sein, durch Sputtern, Aufdampfen oder Galvanisieren oder ähnlichem aufgebracht sein oder mittels einer Paste aufgedruckt sein, welche elektrisch leitende Partikel enthält, wie beispielsweise Silber- oder Kupferpaste. Dabei kann die elektrisch leitende erste Funktionsschicht in strukturierter Form oder vollflächig aufgebracht werden, wobei nach einem vollflächigen Auftrag oftmals nachfolgend eine Strukturierung, beispielsweise mittels Stanzen, Ätzen oder ähnlichem erfolgt.

Weiterhin hat es sich bewährt, wenn die mindestens eine zweite Funktionsschicht und die zusätzlichen Schichten, die mittels eines Haftklebers auf dem ersten Trägersubstrat fixiert sind, Bestandteil eines Polymerelektronikchips sind. Ein solcher Polymerelektronikchip ist im Fall, dass die erste Funktionsschicht eine Antennenstruktur bildet, vorzugsweise ein Transponderchip.

Um flexible elektrische Bauteile auszubilden, hat es sich insbesondere bewährt, wenn das erste Trägersubstrat bandförmig und flexibel ausgebildet ist. Dabei können auf einem ersten Trägersubstrat nebeneinander mehrere gleichartige elektrische Bauteile ausgebildet werden, welche nach ihrer Bildung durch Stanzen oder Schneiden vereinzelt werden können. Sofern das zweite Trägersubstrat nicht entfernt wurde, kann dieses eine weitere Barriereschicht umfassen und damit eine Verkapselung für das elektrische Bauteil bilden.

Weiterhin ist es möglich, dass das erste Trägersubstrat eine Ablöseschicht auf seiner ersten Seite aufweist, die ein Ablösen des ausgebildeten elektrischen Bauteils ermöglicht. Dies erfolgt analog zu einer Transferfolientechnik, wie sie für Heißprägefolien hinreichend bekannt ist.

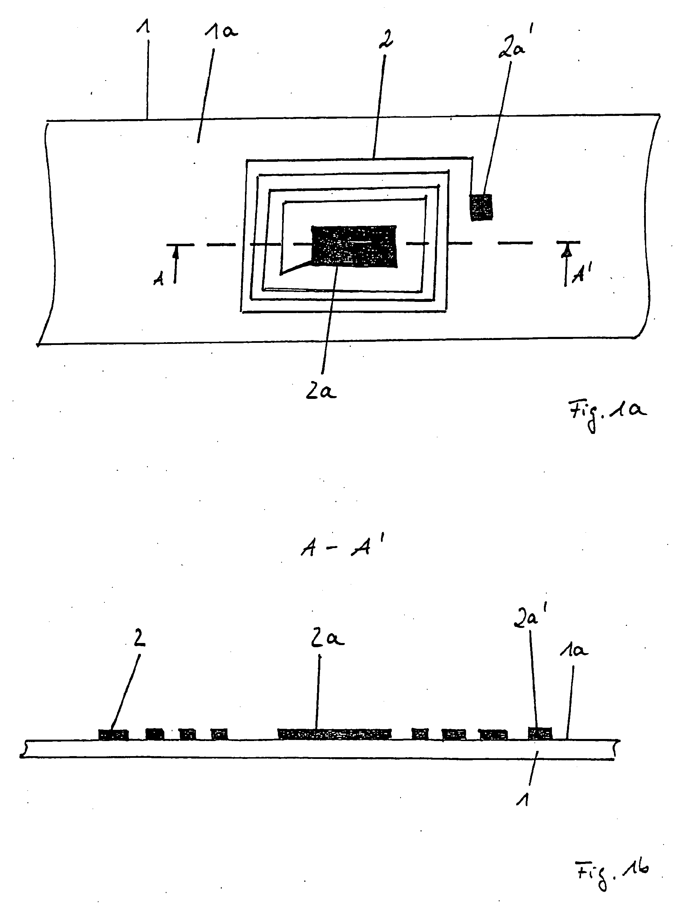

Das erfindungsgemäße elektrische Bauteil ist insbesondere dazu geeignet, flexible RFID-Tags, wie beispielsweise für elektronische Tickets, den Diebstahlschutz, die Gepäckkontrolle oder beispielsweise elektronische Briefmarken, elektronische Wasserzeichen und vieles andere mehr auszubilden. Das elektrische Bauteil ist weiterhin dazu geeignet, flexible Bauteile aus der Gruppe der RFID-Tags, Leuchtdioden (z.B. OLEDs), Solarzellen, LCDs, PDLCDs, Displays, Datenspeicher, Batterien, gedruckten Flachbatterien und Sensoren auszubilden. Die nachfolgenden Figuren 1a bis 8 sollen das erfindungsgemäße Verfahren sowie das erfindungsgemäße elektrische Bauteil beispielhaft erläutern.
So zeigt:
- Figur 1a: ein erstes Trägersubstrat mit einer ersten elektrisch leitenden Funktionsschicht;
- Figur 1b: das erste Trägersubstrat aus Figur 1a im Schnitt A-A' ;
- Figur 2a: ein zweites Trägersubstrat mit einem Polymerelektronikchip und einer zweiten elektrisch leitenden Funktionsschicht;
- Figur 2b: einen Querschnitt durch das zweite Trägersubstrat aus Figur 2a im Bereich B-B';
- Figur 2c: ein weiteres zweites Trägersubstrat mit einem Funktionsschichtaufbau und einer zweiten elektrisch leitenden Funktionsschicht;
- Figur 2d: einen Querschnitt durch das zweite Trägersubstrat aus Figur 2c im Bereich B1-B1 ;
- Figur 3a: ein drittes Trägersubstrat mit Haftkleberpunkten 3;
- Figur 3b: einen Querschnitt C-C' durch das dritte Trägersubstrat gemäß Figur 3a;
- Figur 4a: das erste Trägersubstrat aus Figur 1a, auf welches die Haftkleberpunkte gemäß Figur 3a übertragen wurden;
- Figur 4b: einen Schnitt durch das erste Trägersubstrat gemäß Figur 4a im Bereich D-D';
- Figur 5a: das erste Trägersubstrat gemäß Figur 4b, auf welches das zweite Trägersubstrat gemäß Figur 2a aufgelegt wurde;
- Figur 5b: den Verbund aus erstem Trägersubstrat und zweitem Trägersubstrat gemäß Figur 5a nach Aktivierung der Kleberpunkte;
- Figur 6: ein Rolle-zu-Rolle Verfahren zum Aufbringen von Haftkleberpunkten auf ein erstes Trägersubstrat;
- Figur 7: ein Rolle-zu-Rolle Verfahren zum Übertragen des Polymerelektronikchips gemäß Figur 2a inklusive der zweiten elektrisch leitenden Funktionsschicht auf das erste Trägersubstrat;
- Figur 8: ein elektrisches Bauteil auf einem ersten Trägersubstrat.

Figur 1a zeigt in Aufsicht ein erstes Trägersubstrat 1 mit einer ersten Seite 1a. Auf der ersten Seite 1a des ersten Trägersubstrats 1 ist eine erste Funktionsschicht 2 eines elektrischen Bauteils mittels Drucken aufgebracht. Die erste Funktionsschicht 2 wurde aus Kupferpaste in Form einer Antennenstruktur aufgedruckt, wobei erste elektrisch leitende Kontaktbereiche 2a, 2a'ausgebildet wurden.

Figur 1b zeigt den Schnitt A - A' durch das erste Trägersubstrat 1 gemäß Figur 1a. Es ist zu erkennen, dass auf der ersten Seite 1a des ersten Trägersubstrats 1 die erste Funktionsschicht 2 angeordnet ist, welche die ersten elektrisch leitenden Kontaktbereiche 2a, 2a' ausbildet.

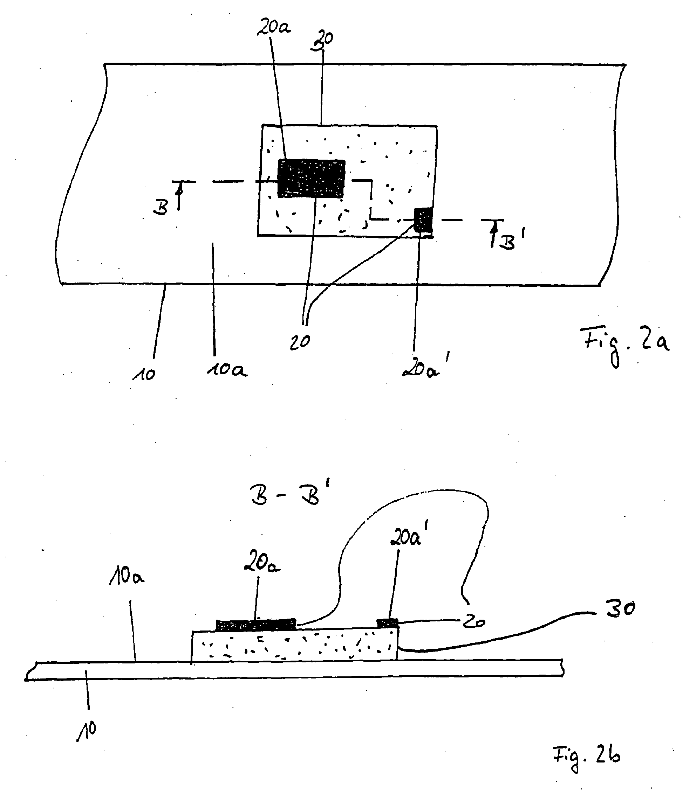

Figur 2a zeigt ein zweites Trägersubstrat 10 mit einer ersten Seite 10a in Aufsicht. Auf der ersten Seite 10a des zweiten Trägersubstrats 10 ist ein Polymerelektronikchip 30 ausgebildet, der eine zweite Funktionsschicht 20 umfasst. Von der zweiten Funktionsschicht 20, welche elektrisch leitend ist und ebenfalls aus Kupfer besteht, sind lediglich die zweiten elektrisch leitenden Kontaktbereiche 20a, 20a' zu erkennen. Figur 2b zeigt einen Schnitt B - B' durch das zweite Trägersubstrat 10 gemäß Figur 2a. Es ist zu erkennen, dass der Polymerelektronikchip 30 auf der ersten Seite 10a des zweiten Trägersubstrats 10 angeordnet ist. Dabei sind die zweiten elektrisch leitenden Kontaktbereiche 20a, 20a' gut zu erkennen, welche frei liegen.

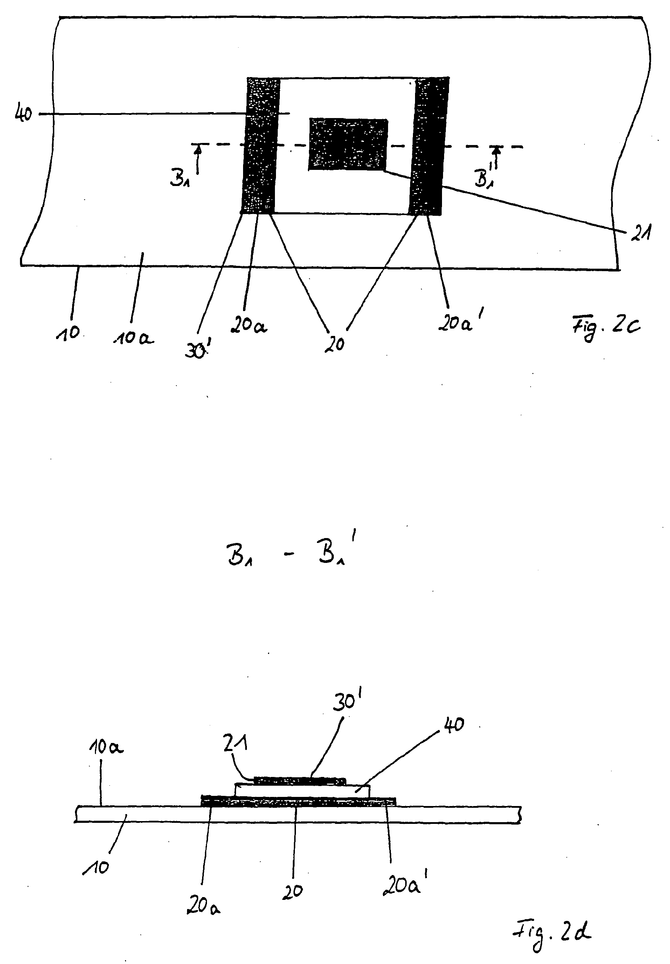

Figur 2c zeigt ein weiteres zweites Trägersubstrat 10 mit einer ersten Seite 10a in Aufsicht. Auf der ersten Seite 10a des zweiten Trägersubstrats 10 ist ein Funktionsschichtaufbau 30' ausgebildet, der eine elektrisch leitende zweite Funktionsschicht 20 sowie eine dritte elektrisch leitende Funktionsschicht 21 umfasst. Der Funktionsschichtaufbau 30' umfasst weiterhin mindestens eine zusätzliche Schicht 40. Von der zweiten Funktionsschicht 20, welche elektrisch leitend ist und ebenfalls aus Kupfer besteht, sind lediglich die zweiten elektrisch leitenden Kontaktbereiche 20a, 20a' zu erkennen.

Figur 2d zeigt einen Schnitt B₁ - B₁' durch das zweite Trägersubstrat 10 gemäß Figur 2c. Es ist zu erkennen, dass der Funktionsschichtaufbau 30' auf der ersten Seite 10a des zweiten Trägersubstrats 10 angeordnet ist. Dabei sind die zweiten elektrisch leitenden Kontaktbereiche 20a, 20a' sowie die dritte Funktionsschicht 21 gut zu erkennen, welche frei liegen und mittels des erfindungsgemäßen Verfahrens mit weiteren Schichten elektrisch leitend verbunden werden können.

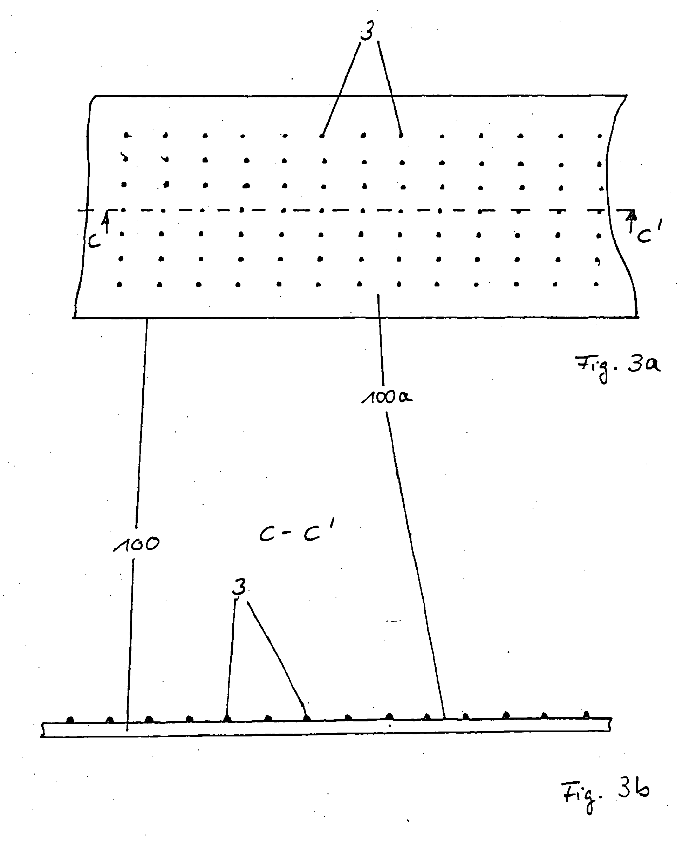

Figur 3a zeigt nun ein drittes Trägersubstrat 100, auf dessen einer Seite 100a in einem Raster Haftkleberpunkte 3 angeordnet sind. Die Haftkleberpunkte 3 sind vom dritten Trägersubstrat 100 ablösbar, wobei das Trägersubstrat 100 mit einer Ablöseschicht, welche hier nicht dargestellt ist, beschichtet ist.

Figur 3b zeigt den Schnitt C - C' durch das dritte Trägersubstrat 100 gemäß Figur 3a. Es sind die Haftkleberpunkte 3 auf dem dritten Trägersubstrat 100 zu erkennen.

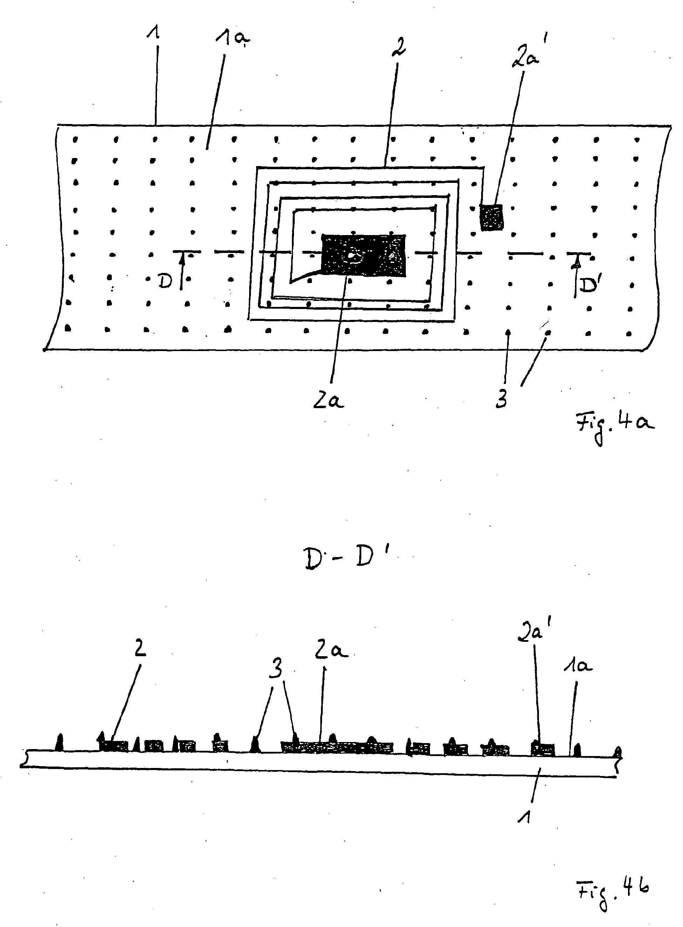

Figur 4a zeigt das erste Trägersubstrat 1 gemäß Figur 1a, auf welches die Haftkleberpunkte 3 gemäß Figur 3a übertragen wurden.

Figur 4b zeigt das erste Trägersubstrat 1 gemäß Figur 4a im Schnitt D - D'. Es ist zu erkennen, dass die Haftkleberpunkte 3 sowohl die beschichtete als auch die unbeschichtete Oberfläche des ersten Trägersubstrats 1 bedecken. In gleicher Weise kann auch das Trägersubstrat 10 gemäß Figur 2c behandelt werden. So befinden sich Haftkleberpunkte 3 sowohl auf der ersten Seite 1a des ersten Trägersubstrats 1 wie auch auf der ersten Funktionsschicht 2 bzw. den durch die erste Funktionsschicht 2 ausgebildeten ersten elektrisch leitenden Kontaktbereichen 2a, 2a'.

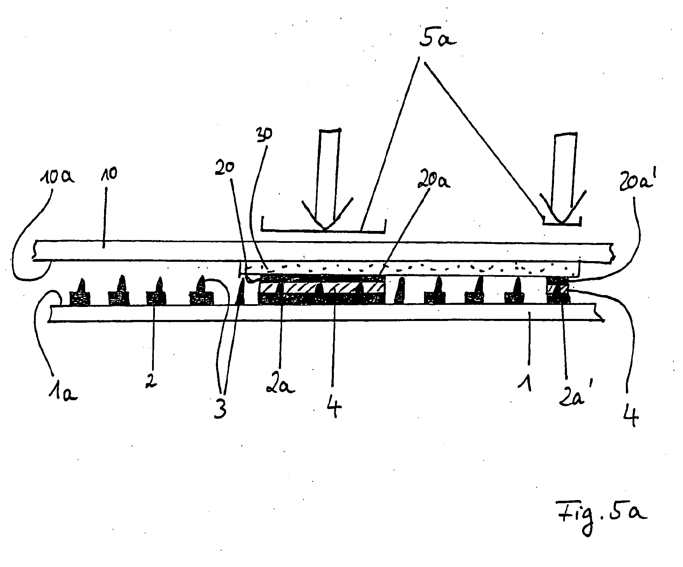

Figur 5a zeigt das erste Trägersubstrat 1 gemäß Figur 4b, welches mit einem zweiten Trägersubstrat 10 gemäß Figur 2a zusammengeführt wurde. In gleicher Weise kann auch mit dem Trägersubstrat 10 gemäß Figur 2c verfahren werden, wobei die ersten elektrisch leitenden Kontaktbereiche auf dem ersten Trägersubstrat jedoch dazu passend ausgestaltet sein müssen und keine Antenne bilden müssen.

Vor dem Zusammenführen des ersten Trägersubstrats 1 mit dem zweiten Trägersubstrat 10 gemäß Figur 2a wurde auf die ersten elektrisch leitenden Kontaktbereiche 2a, 2a' der ersten Funktionsschicht 2 ein Leitkleber 4 aufgetragen. Der Leitkleber 4 verbindet den ersten elektrisch leitenden Kontaktbereich 2a, 2a' mit dem zweiten elektrisch leitenden Kontaktbereich 20a, 20a'. Im Bereich 5a sind Andruckstempel vorgesehen, welche auf eine Temperatur von 50 °C beheizt sind und welche eine gute Verbindung zwischen den ersten elektrisch leitenden Kontaktbereichen 2a, 2a' und den zweiten elektrisch leitenden Kontaktbereichen 20a, 20a' herstellen.

Den Andruckstempeln gegenüber sind gegebenenfalls Gegendruckstempel oder Gegendruckplatten vorzusehen, die ebenfalls beheizt sein können und die es ermöglichen, dass ein definierter Druck auf den Verbund aufgebracht werden kann. Nachdem der Haftkleber 3 bzw, die Haftkleberpunkte in trockener Form vorliegen, dienen diese als vorzugsweise elastische Abstandshalter zwischen dem Polymerelektronikchip 30 und der ersten Funktionsschicht 2 bzw. dem ersten Trägersubstrat 1.

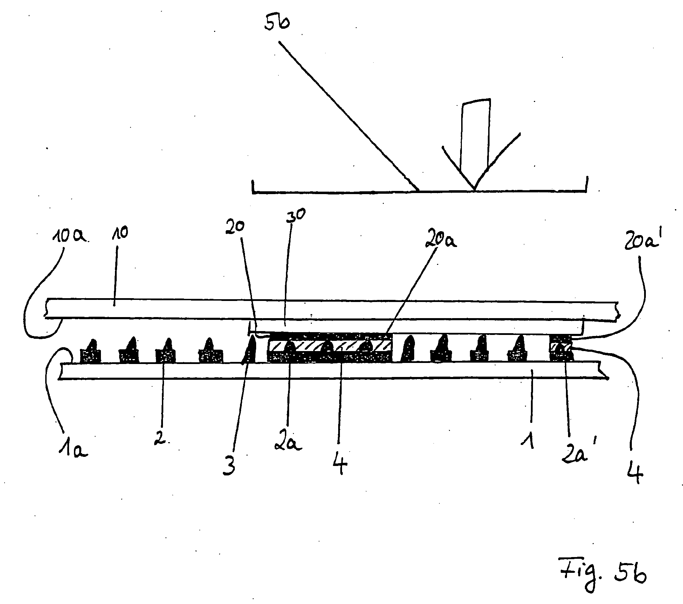

Figur 5b zeigt den Verbund gemäß Figur 5a, wobei im Bereich des Polymerelektronikchips 30 eine Stempeleinheit 5b vorgesehen ist, welche bei einer Temperatur von 80 °C einen Druck auf den Verbund ausübt, derart, dass die Haftkleberpunkte 3 aktiviert werden und eine feste Verbindung zwischen dem Polymerelektronikchip 30 und dem ersten Trägersubstrat 1 bzw. der ersten Funktionsschicht 2 hergestellt wird. Der Stempeleinheit gegenüber sind gegebenenfalls Gegendruckstempel oder Gegendruckplatten vorzusehen, die ebenfalls beheizt sein können und die es ermöglichen, dass ein definierter Druck auf den Verbund aufgebracht werden kann. Das zweite Trägersubstrat 10 kann bereits zuvor abgezogen werden oder danach entfernt werden. Es kann aber auch auf dem Polymerelektronikchip 30 verbleiben.

Alternativ zu der Darstellung in den Figuren 5a und 5b kann eine Aktivierung der Haftkleberpunkte 3 bereits bei Aufbringen des Polymerelektronikchips erfolgen und der Leitkleber erst danach ausgehärtet werden. Dies hat den Vorteil, dass insbesondere bei Verwendung von druckaktivierbarem Kleber zur Ausbildung der Haftkleberpunkte diese ohne eine Temperatureinwirkung aktiviert werden können, so dass ein empfindlicher Polymerelektronikchip lediglich im Bereich der Kontaktbereiche erwärmt wird, sofern ein temperaturempfindlicher Leitkleber verwendet wird.

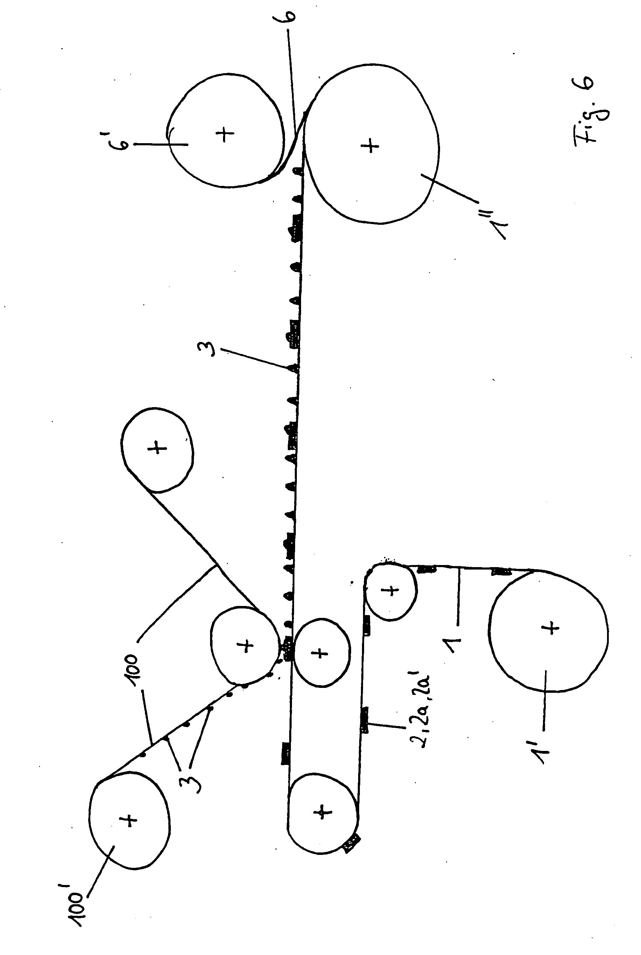

Figur 6 zeigt ein Rolle-zu-Rolle Verfahren zum Aufbringen von Haftkleberpunkten 3 auf das erste Trägersubstrat 1 gemäß Figur 1b. Es wird ein bandförmiges erstes Trägersubstrat 1 auf einer entsprechenden Rolle 1' bereitgestellt und über diverse Umlenkrollen mit einem dritten Trägersubstrat 100 zusammengeführt, welches ebenfalls auf einer Rolle 100' bereitgestellt ist. Die Haftkleberpunkte 3 werden mittels Druck und Temperatur auf das erste Trägersubstrat 1 sowie die erste Funktionsschicht 2 übertragen. Das dritte Trägersubstrat 100 wird anschließend abgezogen und auf eine Rolle aufgewickelt. Das mit Haftkleberpunkten 3 beschichtete erste Trägersubstrat 1 wird mit einem Silikonpapier 6, welches von einer Rolle 6' abgezogen wird, belegt und auf eine weitere Vorratsrolle 1" aufgewickelt.

Alternativ zur Aufwicklung des mit Haftkleberpunkten 3 beschichteten ersten Trägersubstrats 1 auf die Rolle 1" kann auch ein sofortiges Zusammenführen mit dem zweiten Trägersubstrat 10 erfolgen.

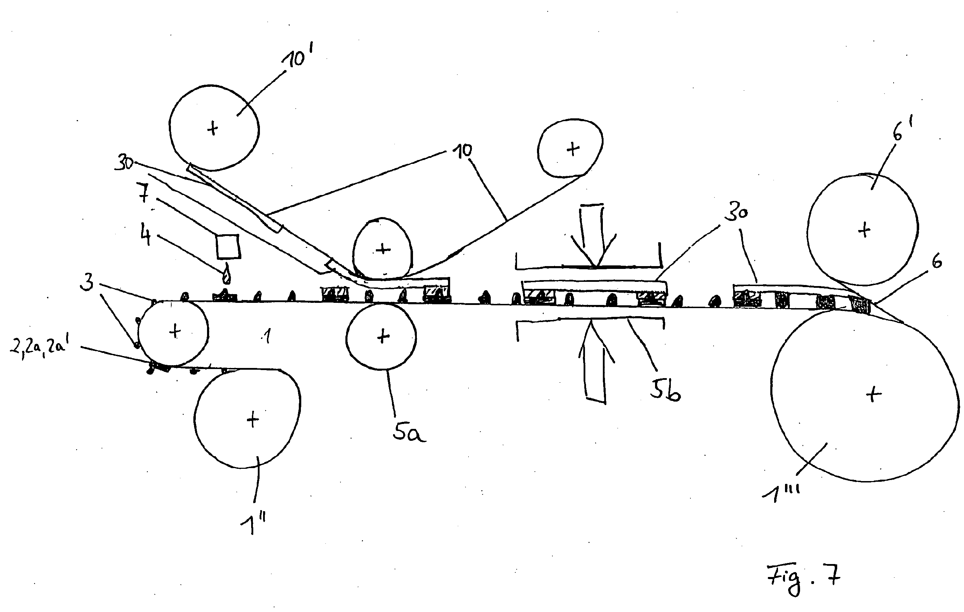

Figur 7 zeigt nun das Zusammenführen des Materials der Rolle 1" mit dem zweiten Trägersubstrat 10. Das mit Haftkleberpunkten 3 beschichtete erste Trägersubstrat 1 wird von der Rolle 1" abgezogen, wobei hier die Abtrennung des Silikonpapiers 6 nicht dargestellt ist. Auf die ersten elektrisch leitenden Kontaktbereiche 2a, 2a' der ersten Funktionsschicht 2 wird Leitkleber 4 aufgetropft, welcher mittels einer Auftropfeinheit 7 appliziert wird. Anschließend wird das erste Trägersubstrat 1 mit dem zweiten Trägersubstrat 10 zusammengeführt, wobei der Polymerelektronikchip 30 auf das erste Trägersubstrat 1 übertragen wird. Es sind Andruckrollen 5a vorgesehen, welche den Polymerelektronikchip 30 mit seinen freiliegenden zweiten elektrisch leitfähigen Kontaktbereichen gegen den Leitkleber 4 drücken und aktivieren. Anschließend wird das zweite Trägersubstrat 10 abgezogen, wobei der Polymerelektronikchip 30 auf dem ersten Trägersubstrat 1 verbleibt. Das erste Trägersubstrat 1 wird in eine Einheit 5b weitergefördert, wobei bei einer Temperatur von 80 °C ein Druck auf den Polymerelektronikchip 30 aufgebracht wird und die Haftkleberpunkte 3 aktiviert werden. Anschließend wird das fertiggestellte elektronische Bauteil auf dem ersten Trägersubstrat 1 mit einem Silikonpapier belegt, welches von einer Rolle 6' abgezogen wird, und auf eine Vorratsrolle 1"' aufgewickelt. Alternativ zur Aufwicklung auf die Vorratsrolle 1"' kann das erste Trägersubstrat 1 auch vereinzelt bzw. in Stücke geschnitten werden, so dass die darauf nebeneinander vorliegenden elektronischen Bauteile vereinzelt werden.

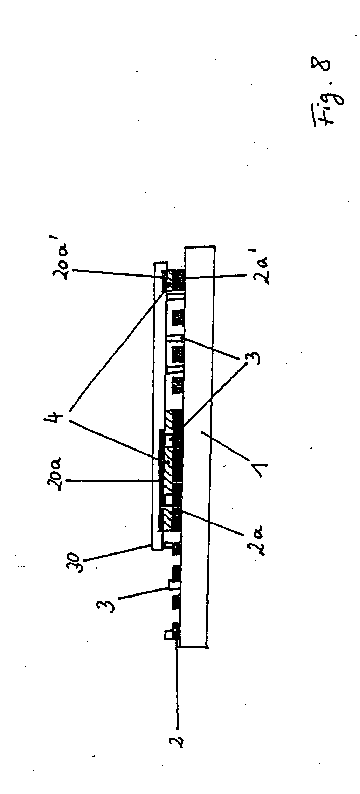

Figur 8 zeigt nun ein elektrisches Bauteil mit dem ersten Trägersubstrat 1, auf welchem die erste Funktionsschicht 2 angeordnet ist. Die erste Funktionsschicht 2 bildet die ersten elektrisch leitenden Kontaktbereiche 2a, 2a' aus. Auf diesen ist ein Leitkleber 4 angeordnet, der die ersten elektrisch leitenden Kontaktbereiche 2a, 2a' mit den zweiten elektrisch leitenden Kontaktbereichen 20a, 20a' des Polymerelektronikchips 30 elektrisch leitend verbindet. Weiterhin ist der aktivierte Haftkleber 3 zu erkennen, der eine feste Fixierung des Polymerelektronikchips 30 auf dem ersten Trägersubstrat 1 bereitstellt. Bei der ersten Funktionsschicht 2 handelt es sich um eine elektrisch leitende Funktionsschicht in Form einer Antennenstruktur, während es sich bei dem Polymerelektronikchip 30 um einen Transponderchip handelt. Das erste Trägersubstrat 1 ist aus einer flexiblen, 10 µm dicken PET-Folie gebildet, so dass ein flexibles bzw. biegsames elektrisches Bauteil resultiert.

Im Hinblick auf die obigen Ausführungen ist erkennbar, dass mittels des erfindungsgemäßen Verfahrens eine Vielzahl von elektrischen Bauteilen gebildet werden kann, ohne dabei erfinderisch tätig werden zu müssen.

## Patentansprüche

1. Verfahren zur Herstellung eines aktiven oder passiven elektrischen Bauteils umfassend folgende Schritte:
- Bereitstellen eines ersten Trägersubstrats (1) und Ausbilden mindestens einer Funktionsschicht des elektrischen Bauteils und gegebenenfalls weiterer Schichten auf einer ersten Seite (1a) des ersten Trägersubstrats (1), wobei mindestens eine erste Funktionsschicht (2) mindestens einen ersten freiliegenden elektrisch leitenden Kontaktbereich (2a, 2a') ausbildet;
- Bereitstellen eines zweiten Trägersubstrats (10) und Aufbringen mindestens einer weiteren Funktionsschicht des elektrischen Bauteils und gegebenenfalls zusätzlicher Schichten auf eine erste Seite (10a) des zweiten Trägersubstrats (10), wobei mindestens eine zweite Funktionsschicht (20) mindestens einen freiliegenden zweiten elektrisch leitenden Kontaktbereich (20a, 20a') ausbildet;
- punkt- und/oder linienförmiges und/oder dekorförmiges Aufbringen eines elektrisch isolierenden Haftklebers (3) auf die derart beschichtete erste Seite (1a, 10a) des ersten oder zweiten Trägersubstrats (1, 10), wobei der Haftkleber (3) zumindest auf der jeweiligen mindestens einen Funktionsschicht (2, 20) des elektrischen Bauteils und/oder gegebenenfalls weiteren/zusätzlichen Schichten angeordnet wird;
- Auftragen von Leitkleber (4) auf den mindestens einen ersten elektrisch leitenden Kontaktbereich (2a, 2a') und/oder den mindestens einen zweiten elektrisch leitenden Kontaktbereich (20a, 20a');
- Zusammenführen des ersten Trägersubstrats (1) und des zweiten Trägersubstrats (10) derart, dass der mindestens eine elektrisch leitende Kontaktbereich (2a, 2a') und der mindestens eine weitere elektrisch leitende Kontaktbereich (20a, 20a') zumindest teilweise überlappen und mittels des Leitklebers (4) elektrisch leitend verbunden werden;
- gegebenenfalls Ablösen des zweiten Trägersubstrats (10); und
- Aktivieren des Haftklebers (3), so dass die mindestens eine zweite Funktionsschicht (20) und gegebenenfalls die zusätzlichen Schichten auf dem beschichteten ersten Trägersubstrat (1) fixiert werden.

2. Verfahren nach Anspruch 1,
**dadurch gekennzeichnet,**
**dass** ein drittes Trägersubstrat (100) bereitgestellt wird, dass der Haftkleber (3) punkt- und/oder linienförmig und/oder dekorförmig auf einer Seite des dritten Trägersubstrats (100) ausgebildet wird und dass der Haftkleber (3) vom dritten Trägersubstrat (100) auf die erste Seite (1a, 10a) des ersten oder zweiten Trägersubstrats (1, 10) übertragen wird.

3. Verfahren nach einem der Ansprüche 1 bis 2,
**dadurch gekennzeichnet,**
**dass** der Haftkleber (3) thermisch und/oder mittels Strahlung und/oder mittels Druck aktiviert wird.

4. Elektrisches Bauteil, erhältlich nach einem der Ansprüche 1 bis 3, umfassend:
- ein erstes Trägersubstrat (1), das auf einer ersten Seite (1a) mindestens eine Funktionsschicht des elektrischen Bauteils und gegebenenfalls weitere Schichten aufweist; wobei mindestens eine erste Funktionsschicht (2) mindestens einen ersten elektrisch leitenden Kontaktbereich (2a, 2a') aufweist;
- weiterhin mindestens eine weitere Funktionsschicht des elektrischen Bauteils und gegebenenfalls zusätzliche Schichten, wobei mindestens eine zweite Funktionsschicht (20) mindestens einen zweiten elektrisch leitenden Kontaktbereich (20a, 20a') aufweist, welcher senkrecht zur Ebene des ersten Trägersubstrat (1) gesehen zumindest teilweise überlappend mit dem ersten elektrisch leitenden Kontaktbereich (2a, 2a') angeordnet ist;
- einen Leitkleber (4) zwischen dem mindestens einen ersten elektrisch leitenden Kontaktbereich (2a, 2a') und dem mindestens einen zweiten elektrisch leitenden Kontaktbereich (20a, 20a'), welcher zwischen diesen eine elektrisch leitende Verbindung ausbildet; und
- einen punkt- und/oder linienförmig und/oder dekorförmig angeordneten elektrisch isolierenden Haftkleber (3) zwischen der derart mit der mindestens einen ersten Funktionsschicht (2) und gegebenenfalls weiteren Schichten beschichteten ersten Seite (1a) des ersten Trägersubstrats (1) und der mindestens einen zweiten Funktionsschicht (20) und gegebenenfalls zusätzlichen Schichten, der die mindestens eine zweite Funktionsschicht (20) und gegebenenfalls zusätzlichen Schichten auf der beschichteten ersten Seite (1a) des ersten Trägersubstrats (1) fixiert.

5. Elektrisches Bauteil nach Anspruch 4,
**dadurch gekennzeichnet,**
**dass** der Haftkleber (3) punktförmig ausgebildet ist, wobei die Haftkleberpunkte in einem Raster angeordnet sind.

6. Elektrisches Bauteil nach Anspruch 5,
**dadurch gekennzeichnet,**
**dass** die Haftkleberpunkte voneinander in einem Abstand von 0,5 mm bis 5 mm, insbesondere von 1 mm bis 2 mm, beabstandet angeordnet sind.

7. Elektrisches Bauteil nach einem der Ansprüche 4 bis 6,
**dadurch gekennzeichnet,**
**dass** der Haftkleber (3) linienförmig ausgebildet ist, wobei die Haftkleberlinien parallel zueinander und/oder gitterförmig und/oder als Dekor angeordnet sind.

8. Elektrisches Bauteil nach Anspruch 7,
**dadurch gekennzeichnet,**
**dass** die Haftkleberlinien senkrecht zur Ebene des ersten Trägersubstrats gesehen eine Breite im Bereich von 100 µm bis 2 mm aufweisen.

9. Elektrisches Bauteil nach einem der Ansprüche 7 oder 8,
**dadurch gekennzeichnet,**
**dass** parallele Haftkleberlinien voneinander in einem Abstand von 0,5 mm bis 5 mm, insbesondere von 1 mm bis 2 mm, beabstandet angeordnet sind.

10. Elektrisches Bauteil nach einem der Ansprüche 4 bis 9,
**dadurch gekennzeichnet,**
**dass** der Haftkleber (3) dekorförmig ausgebildet ist, wobei der Haftkleber (3) lediglich im Bereich des elektrischen Bauteils angeordnet wird und in mindestens einem Bereich eine Aussparung, in welcher Leitkleber vorhanden ist, aufweist.

11. Elektrisches Bauteil nach einem der Ansprüche 4 bis 10,
**dadurch gekennzeichnet,**
**dass** die mindestens eine erste Funktionsschicht (2) eine strukturierte elektrisch leitende Schicht in Form einer Antennenstruktur ist.

12. Elektrisches Bauteil nach einem der Ansprüche 4 bis 11,
**dadurch gekennzeichnet,**
**dass** die mindestens eine erste Funktionsschicht (2) eine - optional strukturierte - elektrisch leitende Schicht ist, die Bestandteil eines Displays oder einer Stromversorgung ist.

13. Elektrisches Bauteil nach einem der Ansprüche 11 oder 12,
**dadurch gekennzeichnet,**
**dass** die mindestens eine zweite Funktionsschicht (20) und die zusätzlichen Schichten, die mittels des Haftklebers (3) auf dem ersten Trägersubstrat (1) fixiert sind, Bestandteil eines Polymerelektronikchips (30) sind.

14. Elektrisches Bauteil nach den Ansprüchen 11 und 13,
**dadurch gekennzeichnet,**
**dass** der Polymerelektronikchip (30) ein Transponderchip ist.

15. Elektrisches Bauteil nach Anspruch 14,
**dadurch gekennzeichnet,**
**dass** das elektrische Bauteil ein flexibles Bauteil aus der Gruppe der RFID-Tags, Leuchtdioden, Solarzellen, LCDs, PDLCDs, Displays, Datenspeicher, Batterien, gedruckten Flachbatterien und Sensoren ist.

## Claims

1. Method for producing an active or passive electrical component, comprising the following steps:
- providing a first carrier substrate (1) and forming at least one functional layer of the electrical component and, if necessary, further layers on a first side (1a) of the first carrier substrate (1), at least one first functional layer (2) forming at least one first exposed electrically conductive contact area (2a, 2a');
- providing a second carrier substrate (10) and applying at least one further functional layer of the electrical component and, if necessary, additional layers on a first side (10a) of the second carrier substrate (10), at least one second functional layer (20) forming at least one exposed second electrically conductive contact area (20a, 20a');
- point- and/or line-shaped and/or design-shaped applying of an electrically insulating contact adhesive (3) to the first side (1a, 10a), coated in this manner, of the first or second carrier substrate (1, 10), the contact adhesive (3) being arranged at least on the respective at least one functional layer (2, 20) of the electrical component and/or, if necessary, other/additional layers;
- applying conductive adhesive (4) to the at least one first electrically conductive contact area (2a, 2a') and/or the at least one second electrically conductive contact area (20a, 20a');
- bringing together the first carrier substrate (1) and the second carrier substrate (10) in such a manner that the at least one electrically conductive contact area (2a, 2a') and the at least one further electrically conductive contact area (20a, 20a') overlap at least partially and are electrically conductively connected by means of the conductive adhesive (4);
- if necessary, detaching the second carrier substrate (10); and
- activating the contact adhesive (3) so that the at least one second functional layer (20) and, if necessary, the additional layers are fixed on the coated first carrier substrate (1).

2. Method according to Claim 1, **characterized in that** a third carrier substrate (100) is provided, **in that** the contact adhesive (3) is formed point- and/or line-shaped and/or design-shaped on one side of the third carrier substrate (100) and **in that** the contact adhesive (3) is transferred from the third carrier substrate (100) to the first side (1a, 10a) of the first or second carrier substrate (1, 10).

3. Method according to one of Claims 1 to 2, **characterized in that** the contact adhesive (3) is activated thermally and/or by means of radiation and/or by means of pressure.

4. Electrical component, which can be obtained in accordance with one of Claims 1 to 3, comprising:
- a first carrier substrate (1) which exhibits at least one functional layer of the electrical component and, if necessary, other layers on a first side (1a), at least one first functional layer (2) exhibiting at least one first electrically conductive contact area (2a, 2a'),
- furthermore at least one further functional layer of the electrical component and, if necessary, additional layers, at least one second functional layer (20) exhibiting at least one second electrically conductive contact area (20a, 20a') which, seen perpendicularly to the plane of the first carrier substrate (1), is arranged at least partially overlapping with the first electrically conductive contact area (2a, 2a');
- a conductive adhesive (4) between the at least one first electrically conductive contact area (2a, 2a') and the at least one second electrically conductive contact area (20a, 20a') which forms an electrically conductive connection between these; and
- an electrically insulating contact adhesive (3), which is arranged in a point- and/or line-shaped and/or design-shaped manner, between the first side (1a), coated in this manner with the at least one first functional layer (2) and, if necessary, other layers, of the first carrier substrate (1) and the at least one second functional layer (20) and, if necessary, additional layers, which fixes the at least one second functional layer (20) and, if necessary, other layers on the coated first side (1a) of the first carrier substrate (1).

5. Electrical component according to Claim 4, **characterized in that** the contact adhesive (3) is formed to be point-shaped, the contact adhesive points being arranged in a grid pattern.

6. Electrical component according to Claim 5, **characterized in that** the contact adhesive points are arranged to be spaced apart from one another at a distance of 0.5 mm to 5 mm, particularly of 1 mm to 2 mm.

7. Electrical component according to one of Claims 4 to 6, **characterized in that** the contact adhesive (3) is formed to be line-shaped, the contact adhesive lines being arranged in parallel with one another and/or in a grid-shaped manner and/or as design.

8. Electrical component according to Claim 7, **characterized in that** the contact adhesive lines, seen perpendicularly to the plane of the first carrier substrate, exhibit a width within a range from 100 µm to 2 mm.

9. Electrical component according to one of Claims 7 or 8, **characterized in that** parallel contact adhesive lines are arranged spaced apart from one another at a distance of 0.5 mm to 5 mm, particularly of 1 mm to 2 mm.

10. Electrical component according to one of Claims 4 to 9, **characterized in that** the contact adhesive (3) is formed in a design-shaped manner, the contact adhesive (3) being arranged only in the area of the electrical component and exhibiting in at least one area an opening in which conductive adhesive is present.

11. Electrical component according to one of Claims 4 to 10, **characterized in that** the at least one first functional layer (2) is a patterned electrically conductive layer in the form of an antenna structure.

12. Electrical component according to one of Claims 4 to 11, **characterized in that** the at least one first functional layer (2) is an - optionally patterned - electrically conductive layer which is a component of a display or of a power supply.

13. Electrical component according to one of Claims 11 or 12, **characterized in that** the at least one second functional layer (20) and the additional layers which are fixed on the first carrier substrate (1) by means of the contact adhesive (3) are a component of a polymer electronic chip (30).

14. Electrical component according to Claims 11 and 13, **characterized in that** the polymer electronic chip (30) is a transponder chip.

15. Electrical component according to Claim 14, **characterized in that** the electrical component is a flexible component from the group of RFID tags, light emitting diodes, solar cells, LCDs, PDLCDs, displays, data memories, batteries, printed flat batteries and sensors.

## Revendications

1. Procédé de fabrication d'un composant électrique actif ou passif, comportant les étapes suivantes :
- préparation d'un premier substrat support (1) et formation d'au moins une couche fonctionnelle du composant électrique et, le cas échéant, d'autres couches sur une première face (1a) du premier substrat support (1), au moins une première couche fonctionnelle (2) formant au moins une première zone de contact (2a, 2a') électroconductrice dégagée ;
- préparation d'un deuxième substrat support (10) et application d'au moins une autre couche fonctionnelle du composant électrique et, le cas échéant, des couches supplémentaires sur une première face (10a) du deuxième substrat support (10), au moins une deuxième couche fonctionnelle (20) formant au moins une deuxième zone de contact (20a, 20a') électroconductrice dégagée ;
- application par points et/ou par lignes et/ou en forme de décor d'une colle autoadhésive (3) électro-isolante sur la première face (1a, 10a) ainsi revêtue du premier ou deuxième substrat support (1, 10), la colle autoadhésive (3) étant disposée au moins sur ladite au moins une couche fonctionnelle (2, 20) respective du composant électrique et/ou, le cas échéant, d'autres couches ou couches supplémentaires ;
- dépôt d'une colle conductrice (4) sur ladite au moins une première zone de contact (2a, 2a') électroconductrice et/ou ladite au moins une deuxième zone de contact (20a, 20a') électroconductrice ;
- réunion du premier substrat support (1) et du deuxième substrat support (10), de telle sorte que ladite au moins une zone de contact (2a, 2a') électroconductrice et ladite au moins une autre zone de contact (20a, 20a') électroconductrice se chevauchent au moins partiellement et sont reliées l'une à l'autre de manière électroconductrice par la colle conductrice (4) ;
- le cas échéant, enlèvement du deuxième substrat support (10) ; et
- activation de la colle autoadhésive (3), de telle sorte que ladite au moins une deuxième couche fonctionnelle (20) et, le cas échéant, les couches supplémentaires sont fixées sur le premier substrat support (1) revêtu.

2. Procédé selon la revendication 1, **caractérisé en ce qu'**un troisième substrat support (100) est préparé, **en ce que** la colle autoadhésive (3) est appliquée par points et/ou par lignes et/ou en forme de décor sur une face du troisième substrat support (100), et **en ce que** la colle autoadhésive (3) est transférée du troisième substrat support (100) sur la première face (1a, 10a) du premier ou du deuxième substrat support (1, 10).

3. Procédé selon l'une quelconque des revendications 1 à 2, **caractérisé en ce que** la colle autoadhésive (3) est activée thermiquement et/ou par rayonnement et/ou par pression.

4. Composant électrique, réalisable selon une des revendications 1 à 3, comportant :
- un premier substrat support (1), dont une première face (1a) comporte au moins une couche fonctionnelle du composant électrique et, le cas échéant, des autres couches, au moins une première couche fonctionnelle (2) comportant au moins une première zone de contact (2a, 2a') électroconductrice ;
- en outre, au moins une autre couche fonctionnelle du composant électrique et, le cas échéant, des couches supplémentaires, au moins une deuxième couche fonctionnelle (20) comportant au moins une deuxième zone de contact (20a, 20a') électroconductrice qui, observée perpendiculairement au plan du premier substrat support (1), est disposée en chevauchement au moins partiel avec la première zone de contact (2a, 2a') électroconductrice ;
- une colle conductrice (4) entre ladite au moins une première zone de contact (2a, 2a') électroconductrice et ladite au moins une deuxième zone de contact (20a, 20a') électroconductrice, laquelle colle forme entre lesdites zones une liaison électroconductrice ; et
- une colle autoadhésive (3) électro-isolante, disposée par points et/ou par lignes et/ou en forme de décor entre la première face (1 a) du premier substrat support (1), ainsi revêtue avec ladite au moins une première couche fonctionnelle (2) et, le cas échéant, avec d'autres couches, et ladite au moins une deuxième couche fonctionnelle (20) et, le cas échéant, des couches supplémentaires, laquelle colle fixe ladite au moins une deuxième couche fonctionnelle (20) et, le cas échéant, des couches supplémentaires sur la première face (1a) revêtue du premier substrat support (1).

5. Composant électrique selon la revendication 4, **caractérisé en ce que** la colle autoadhésive (3) est appliquée par points, lesdits points de colle autoadhésive étant disposés selon une trame.

6. Composant électrique selon la revendication 5, **caractérisé en ce que** les points de colle autoadhésive sont écartés les uns des autres selon une distance de 0,5 mm à 5 mm, en particulier de 1 mm à 2 mm.

7. Composant électrique selon l'une quelconque des revendications 4 à 6, **caractérisé en ce que** la colle autoadhésive (3) est appliquée par lignes, les lignes de colle autoadhésive étant disposées parallèlement entre elles et/ou en forme de grille et/ou en formant un décor.

8. Composant électrique selon la revendication 7, **caractérisé en ce que** les lignes de colle autoadhésive, observées perpendiculairement au plan du premier substrat support, ont une largeur dans une plage de 100 µm à 2 mm.

9. Composant électrique selon la revendication 7 ou 8, **caractérisé en ce que** des lignes de colle autoadhésive sont écartées les unes des autres selon une distance de 0,5 mm à 5 mm, en particulier de 1 mm à 2 mm.

10. Composant électrique selon l'une quelconque des revendications 4 à 9, **caractérisé en ce que** la colle autoadhésive (3) est appliquée en forme de décor, la colle autoadhésive (3) étant disposée uniquement dans la zone du composant électrique et comportant, dans au moins une zone, un évidement, dans lequel est disposée une colle conductrice.

11. Composant électrique selon l'une quelconque des revendications 4 à 10, **caractérisé en ce que** ladite au moins une première couche fonctionnelle (2) est une couche électroconductrice structurée, formant une structure d'antenne.

12. Composant électrique selon l'une quelconque des revendications 4 à 11, **caractérisé en ce que** ladite au moins une première couche fonctionnelle (2) est une couche électroconductrice - facultativement structurée -, laquelle fait partie intégrante d'un afficheur ou d'une alimentation de courant.

13. Composant électrique selon la revendication 11 ou 12, **caractérisé en ce que** ladite au moins une deuxième couche fonctionnelle (20) et les couches supplémentaires, qui sont fixées sur le premier substrat support (1) au moyen de la colle autoadhésive (3), font partie intégrante d'une puce électronique polymère (30).

14. Composant électrique selon les revendications 11 et 13, **caractérisé en ce que** la puce électronique polymère (30) est une puce transpondeuse.

15. Composant électrique selon la revendication 14, **caractérisé en ce que** le composant électrique est un composant flexible issu du groupe des étiquettes d'identification par radiofréquence, des diodes électroluminescentes, des cellules solaires, des afficheurs à cristaux liquides, des afficheurs PDLCD, des afficheurs, des mémoires de données, des batteries, des batteries plates imprimées et des capteurs.
